# EUROPEAN PATENT APPLICATION

(11) **EP 4 832 058 A1**
(43) Date of publication of application: **28.10.2026**
(21) Application number: 24921693.8
(22) Date of filing: 04.12.2024
(51) Int. Cl.: H01L 23/373, H01L 23/367, H01L 23/488, H01L 25/18

(54) **POWER SEMICONDUCTOR MODULE HAVING DOUBLE-SIDED HEAT DISSIPATION, AND POWER SEMICONDUCTOR PACKAGING ASSEMBLY**

(30) Priority: 02.02.2024 CN 202410150085
(71) Applicant: Leadrive Technology (Shanghai) Co. Ltd, Shanghai 201203 (CN)
(72) Inventor: XIA, Yuxin, Shanghai 201203 (CN); WANG, Mingyang, Shanghai 201203 (CN)
(74) Representative: Ridderbusch, Oliver
(86) International application number: PCT/CN2024/136686
(87) International publication number: WO 2025/161671

(57) **Abstract**

The present invention provides a power semiconductor module with double-sided cooling and a packaging assembly. The module comprises a first substrate and a second substrate, each of which comprises a connection copper layer, an insulating dielectric layer and an outer copper layer that are arranged in a bonded configuration, with the insulating dielectric layer being disposed between the connection copper layer and the outer copper layer. The connection copper layer of the first substrate faces the connection copper layer of the second substrate. An upper bridge arm chip is disposed on the connection copper layer of the first substrate, the connection copper layer of the first substrate being connected to a bump surface of the upper bridge arm chip, and the connection copper layer of the second substrate being connected to an upper surface of the upper bridge arm chip. A lower bridge arm chip is disposed on the connection copper layer of the second substrate, the connection copper layer of the second substrate being connected to a bump surface of the lower bridge arm chip, and the connection copper layer of the first substrate being connected to an upper surface of the lower bridge arm chip. Signal terminals and power terminals are respectively disposed on both sides between the connection copper layer of the first substrate and the connection copper layer of the second substrate. The technical solution of the present invention can reduce the dimensions of the power semiconductor module and the packaging assembly while achieving double-sided cooling.

## Description

### Technical Field

The present invention relates to the technical field of semiconductor devices, and in particular to a power semiconductor module with double-sided cooling and a packaging assembly.

### Background Art

Power semiconductor modules are widely used in scenarios requiring electrical energy conversion, such as industrial inverters, converters and automotive electrode controllers. Traditional power semiconductor modules employ a single-sided cooling structure, in which heat generated by power chip losses is conducted in a single direction through a DBC substrate and a base plate to a heat sink. However, for power semiconductors with high integration or high power, since the chips generate a large amount of heat, single-sided cooling is inefficient and unable to meet the cooling demand for higher heat loads. Consequently, there is an increasing need for double-sided cooling solutions.

Existing double-sided cooling solutions suffer from the problems of complex manufacturing processes, high implementation difficulty and large module footprint. In automotive modules, in particular, there are stringent requirements for volume and power density. Therefore, there is a need for a double-sided cooling power semiconductor module having a small overall size and a high power density.

### Summary of the Invention

In order to overcome the above-mentioned technical drawbacks, an object of the present invention is to provide a power semiconductor module with double-sided cooling and a packaging assembly, which are capable of performing double-sided cooling while having relatively small thickness and lateral dimensions, as well as a relatively high power density.

The present invention discloses a power semiconductor module with double-sided cooling, which:
comprises a first substrate and a second substrate, each of the first substrate and the second substrate comprising a connection copper layer, an insulating dielectric layer and an outer copper layer that are arranged in a bonded configuration, the insulating dielectric layer being disposed between the connection copper layer and the outer copper layer;
the first substrate and the second substrate are spaced apart and overlap in a vertical direction, such that the connection copper layer of the first substrate faces the connection copper layer of the second substrate;
an upper bridge arm chip is disposed on the connection copper layer of the first substrate, the connection copper layer of the first substrate being connected to a bump surface of the upper bridge arm chip, and the connection copper layer of the second substrate being connected to an upper surface of the upper bridge arm chip;
a lower bridge arm chip is disposed on the connection copper layer of the second substrate, the connection copper layer of the second substrate being connected to a bump surface of the lower bridge arm chip, and the connection copper layer of the first substrate being connected to an upper surface of the lower bridge arm chip; and
signal terminals and power terminals are respectively disposed on both sides between the connection copper layer of the first substrate and the connection copper layer of the second substrate.

Preferably, a first conductive spacer is disposed between the connection copper layer of the first substrate and the upper bridge arm chip, the connection copper layer of the first substrate being connected to a bottom surface of the first conductive spacer, and a top surface of the first conductive spacer being connected to the bump surface of the upper bridge arm chip, such that a height of the upper surface of the upper bridge arm chip is equal to a height of an upper surface of the signal terminals;
a second conductive spacer is disposed between the connection copper layer of the second substrate and the lower bridge arm chip, such that the connection copper layer of the second substrate is connected to a bottom surface of the second conductive spacer, and a top surface of the second conductive spacer is connected to the bump surface of the lower bridge arm chip, such that a height of the upper surface of the lower bridge arm chip is equal to a height of a lower surface of the signal terminals.

Preferably, the first substrate and the second substrate are spaced apart and mounted within an insulating housing and overlap in the vertical direction, such that the connection copper layer of the first substrate faces the connection copper layer of the second substrate, and the outer copper layer of the first substrate and the outer copper layer of the second substrate face away from each other and are respectively exposed outside the insulating housing; and
the signal terminals and the power terminals are respectively exposed along a horizontal direction outside both sides of the insulating housing.

Preferably, a positioning groove is provided on a side of the insulating housing adjacent to the signal terminals, offset from a centre line of the insulating housing.

Preferably, the connection copper layer of the first substrate comprises a first main copper foil, a second main copper foil and a third main copper foil that are mutually insulated, and the connection copper layer of the second substrate comprises a fourth main copper foil, a fifth main copper foil and a sixth main copper foil that are mutually insulated;
the first main copper foil is connected to a bump surface of the upper bridge arm chip, the second main copper foil is connected to an upper surface of the lower bridge arm chip, and the sixth main copper foil is connected to a bump surface of the lower bridge arm chip and an upper surface of the upper bridge arm chip;
the power terminals comprise a DC positive terminal, a DC negative terminal and an AC terminal, the DC positive terminal connects the first main copper foil and the fourth main copper foil, the DC negative terminal connects the second main copper foil and the fifth main copper foil, and the AC terminal connects the third main copper foil and the sixth main copper foil;
commutation loop current enters the first main copper foil from the DC positive terminal, flows through the upper bridge arm chip and then enters the sixth main copper foil, flows through the AC terminal and the lower bridge arm chip, and then enters the second main copper foil, and exits the power semiconductor module from the DC negative terminal.

Preferably, the connection copper layer of the first substrate further comprises a first auxiliary copper foil, a second auxiliary copper foil, a third auxiliary copper foil, a fourth auxiliary copper foil and a fifth auxiliary copper foil that are mutually insulated, and the third auxiliary copper foil and the fourth auxiliary copper foil are respectively connected to an upper surface of the lower bridge arm chip;
the connection copper layer of the second substrate further comprises a sixth auxiliary copper foil, a seventh auxiliary copper foil, an eighth auxiliary copper foil, a ninth auxiliary copper foil and a tenth auxiliary copper foil that are mutually insulated, and the seventh auxiliary copper foil and the eighth auxiliary copper foil are respectively connected to an upper surface of the upper bridge arm chip;
the signal terminals comprise a first collector signal terminal, a second collector signal terminal, a first emitter signal terminal, a second emitter signal terminal, a first gate signal terminal and a second gate signal terminal;
the first collector signal terminal connects the first main copper foil and the sixth auxiliary copper foil, the first emitter signal terminal connects the first auxiliary copper foil and the seventh auxiliary copper foil, the first gate signal terminal connects the second auxiliary copper foil and the eighth auxiliary copper foil, the second collector signal terminal connects the fifth auxiliary copper foil and the sixth main copper foil, the second emitter signal terminal connects the fourth auxiliary copper foil and the tenth auxiliary copper foil, and the second gate signal terminal connects the third auxiliary copper foil and the ninth auxiliary copper foil;
commutation loop current enters the first main copper foil from the DC positive terminal, flows through the first collector signal terminal and the upper bridge arm chip and then enters the sixth main copper foil, the seventh auxiliary copper foil and the eighth auxiliary copper foil, respectively flows through the first emitter signal terminal, the first gate signal terminal, the AC terminal, the second collector signal terminal and the lower bridge arm chip, and then enters the second main copper foil, the third auxiliary copper foil and the fourth auxiliary copper foil, flows through the second emitter signal terminal and the second gate signal terminal, and exits the power semiconductor module from the DC negative terminal.

Preferably, the upper bridge arm chip comprises an upper bridge arm IGBT chip and an upper bridge arm diode chip, and the lower bridge arm chip comprises a lower bridge arm IGBT chip and a lower bridge arm diode chip.

Preferably, the connection copper layer of the first substrate is connected to the bump surface of the upper bridge arm chip by vacuum reflow soldering, and the connection copper layer of the second substrate is connected to an upper surface of the upper bridge arm chip by vacuum reflow soldering;
the connection copper layer of the second substrate is connected to the bump surface of the lower bridge arm chip by vacuum reflow soldering, and the connection copper layer of the first substrate is connected to an upper surface of the lower bridge arm chip by vacuum reflow soldering.

Preferably, the first conductive spacer and the second conductive spacer comprise a material selected from aluminium silicon carbide, a molybdenum copper alloy or copper.

The present invention further discloses a power semiconductor packaging assembly, comprising at least three power semiconductor modules as described above, the power semiconductor modules being arranged side by side in the same orientation;
heat sinks being connected to the outer copper layer of the first substrate and the outer copper layer of the second substrate of each of the power semiconductor modules respectively.

After adopting the above-mentioned technical solution, the following beneficial effects are achieved compared with the prior art: by means of flip chip technology, the bump surface of the chip is directly connected to the connection copper layer, thereby reducing the vertical dimension of the power semiconductor module; by mounting the upper bridge arm chip and the lower bridge arm chip in opposite directions on the first substrate and the second substrate respectively, the number of spacers connecting the first substrate and the second substrate can be reduced, thereby reducing the lateral dimension of the power semiconductor module; and by providing exposed outer copper layers, the power semiconductor module is enabled to perform double-sided cooling.

### Brief Description of the Drawings

Figure 1 is a schematic structural view of a power semiconductor module according to the present invention;
Figure 2 is a schematic three-dimensional assembly view of a power semiconductor module according to the present invention;
Figure 3 is a schematic cross-sectional view of a power semiconductor module according to the present invention;
Figure 4 is a schematic structural view of a power semiconductor module according to the present invention;
Figure 5 is a schematic structural view of a first substrate according to the present invention;
Figure 6 is a schematic structural view of a second substrate according to the present invention; and
Figure 7 is a schematic view of a circuit topology according to the present invention.

### Reference signs:

1 - first substrate; 11 - connection copper layer of the first substrate; 12 - insulating dielectric layer of the first substrate; 13 - outer copper layer of the first substrate; 2 - second substrate; 21 - connection copper layer of the second substrate; 22 - insulating dielectric layer of the second substrate; 23 - outer copper layer of the second substrate; 3 - upper bridge arm chip; 4 - lower bridge arm chip; 5 - power terminal; 6 - signal terminal; 7 - insulating housing; 71 - positioning groove; 111 - first main copper foil; 112 - second main copper foil; 113 - third main copper foil; 211 - fourth main copper foil; 212 - fifth main copper foil; 213 - sixth main copper foil; 1110 - first auxiliary copper foil; 1120 - second auxiliary copper foil; 1130 - third auxiliary copper foil; 1140 - fourth auxiliary copper foil; 1150 - fifth auxiliary copper foil; 2110 - sixth auxiliary copper foil; 2120 - seventh auxiliary copper foil; 2130 - eighth auxiliary copper foil; 2140 - ninth auxiliary copper foil; 2150 - tenth auxiliary copper foil.

### Detailed Description of Embodiments

The advantages of the present invention will be further elucidated below with reference to the accompanying drawings and specific embodiments.

Detailed reference will now be made to exemplary embodiments, examples of which are illustrated in the accompanying drawings. Where the following description refers to the drawings, unless otherwise indicated, like numerals in different drawings designate like or similar elements. The implementations described in the following exemplary embodiments are not intended to represent all implementations consistent with the present disclosure. Rather, they are merely examples of apparatuses and methods consistent with certain aspects of the present disclosure as detailed in the appended claims.

The terminology used in the present disclosure is for the purpose of describing particular embodiments only and is not intended to be limiting. The singular forms "a", "the" and "said" as used in the present disclosure and the appended claims are also intended to include the plural forms, unless the context clearly dictates otherwise. It will also be understood that the term "and/or" as used herein refers to and includes any and all possible combinations of one or more of the associated listed items.

It will be understood that, although the terms "first", "second", "third" and the like may be used herein to describe various items of information, these items of information should not be limited by these terms. These terms are only used to distinguish items of information of the same type from one another. For example, without departing from the scope of the present disclosure, first information may be referred to as second information, and similarly, second information may be referred to as first information. Depending on the context, the word "if" as used herein may be construed as "at the time of" or "when" or "in response to determining".

In the description of the present invention, it will be understood that the terms "longitudinal", "transverse", "upper", "lower", "front", "rear", "left", "right", "vertical", "horizontal", "top", "bottom", "inner", "outer" and the like indicate orientations or positional relationships based on those shown in the drawings, and are merely for the purpose of facilitating description of the present invention and simplifying the description, and are not intended to indicate or imply that the referred device or element must have a particular orientation, be constructed and operate in a particular orientation, and therefore should not be construed as limiting the present invention.

In the description of the present invention, unless otherwise provided and limited, it will be understood that the terms "mounted", "connected" and "coupled" are to be construed in a broad sense, and may refer to, for example, a mechanical connection or an electrical connection, an internal communication between two elements, a direct connection, or an indirect connection through an intermediate medium. A person skilled in the art will be able to understand the specific meaning of the above terms in the present invention according to the specific circumstances.

In the following description, suffixes such as "module", "component" or "unit" used for denoting elements are employed merely to facilitate the explanation of the present invention and do not per se have any particular meaning. Accordingly, "module" and "component" may be used interchangeably.

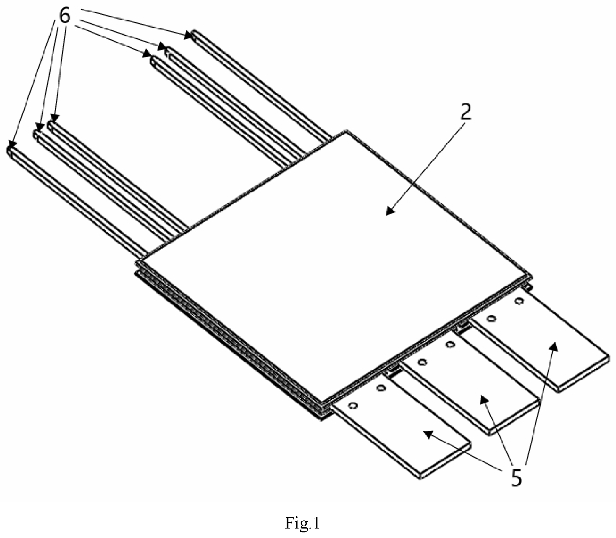

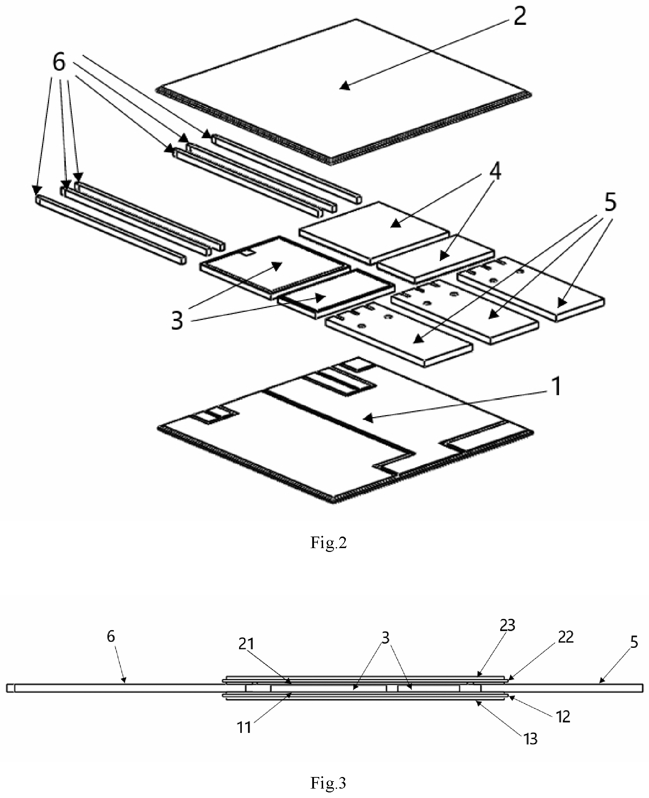

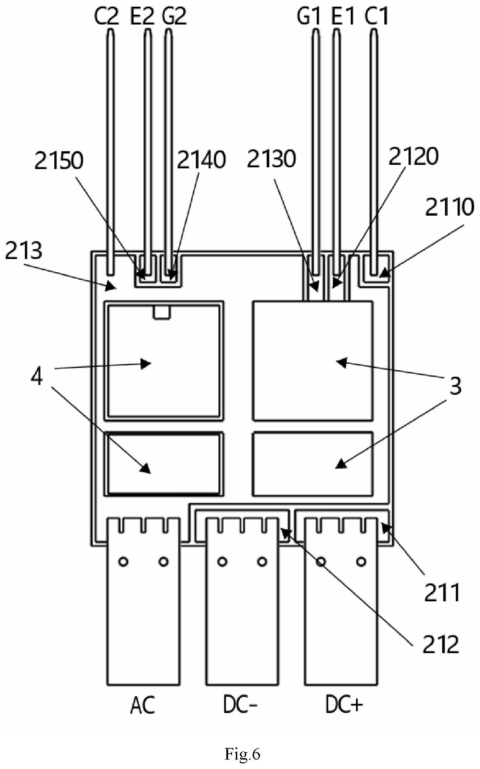

As shown in Figures 1 to 6, the present invention discloses a power semiconductor module with double-sided cooling, which:
comprises a first substrate 1 and a second substrate 2, each of the first substrate 1 and the second substrate 2 comprising a connection copper layer, an insulating dielectric layer and an outer copper layer that are arranged in a bonded configuration, the insulating dielectric layer being disposed between the connection copper layer and the outer copper layer. The first substrate 1 and the second substrate 2 are spaced apart and overlap in a vertical direction, such that the connection copper layer 11 of the first substrate faces the connection copper layer 21 of the second substrate. An upper bridge arm chip 3 is disposed on the connection copper layer 11 of the first substrate, such that the connection copper layer 11 of the first substrate is connected to the bump surface of the upper bridge arm chip 3, and the connection copper layer 21 of the second substrate is connected to the upper surface of the upper bridge arm chip 3. A lower bridge arm chip 4 is disposed on the connection copper layer 21 of the second substrate, the connection copper layer 21 of the second substrate being connected to the bump surface of the lower bridge arm chip 4, and the connection copper layer 11 of the first substrate being connected to the upper surface of the lower bridge arm chip 4. Signal terminals 6 and power terminals 5 are respectively disposed on both sides between the connection copper layer 11 of the first substrate and the connection copper layer 21 of the second substrate.

Specifically, the first substrate 1 and the second substrate 2 are both of a three-layer structure, comprising a connection copper layer, an insulating dielectric layer and an outer copper layer that are sequentially arranged in a bonded configuration. The first substrate 1 and the second substrate 2 are arranged at a spacing facing each other. It will be understood that the first substrate 1 and the second substrate 2 have exactly the same dimensions, such that the first substrate 1 and the second substrate 2 overlap in the vertical direction. After the connection copper layer 11 of the first substrate faces the connection copper layer 21 of the second substrate, the connection copper layer 11 of the first substrate and the connection copper layer 21 of the second substrate can be electrically connected through chips and terminals, so that a commutation loop is formed when the power semiconductor module is energised. The outer copper layer 13 of the first substrate and the outer copper layer 23 of the second substrate face away from each other, enabling heat of the power semiconductor to be transferred to the outside in two directions, so that the power semiconductor module achieves a double-sided cooling effect. Further, heat dissipation equipment may be connected outside the outer copper layer 13 of the first substrate and the outer copper layer 23 of the second substrate respectively, for example, cooling water channels may be arranged in contact with the outer copper layer 13 of the first substrate and the outer copper layer 23 of the second substrate respectively, thereby improving the efficiency of double-sided cooling of the power semiconductor module.

The insulating dielectric layer is disposed between the connection copper layer and the outer copper layer, providing insulation between the connection copper layer and the outer copper layer to avoid interference between the commutation function of the connection copper layer and the heat dissipation function of the outer copper layer. The insulating dielectric layer may be made of zirconia-toughened alumina ceramic, silicon nitride ceramic, aluminium nitride ceramic or the like.

Preferably, the thicknesses of the connection copper layer, the insulating dielectric layer and the outer copper layer may be set to 0.3 mm, 0.32 mm and 0.4 mm respectively.

The signal terminals 6 are configured as strip-shaped metal members and can be connected to a driver board by welding, plug connectors or the like, for extracting signals from different positions of the commutation circuit of the power semiconductor module. The power terminals 5 are configured as plate-shaped metal members and can be connected to capacitors by laser welding or the like, for inputting DC current to and extracting AC current from the power semiconductor module.

In the present invention, the bump surface of a chip refers to the surface obtained by depositing protruding solder bumps on the IO unit side of the chip, and the upper surface of a chip refers to the surface opposite to the bump surface. Connecting the connection copper layer 11 of the first substrate to the bump surface of the upper bridge arm chip 3 and the connection copper layer 21 of the second substrate to the bump surface of the lower bridge arm chip 4 means that the upper bridge arm chip 3 is connected to the connection copper layer 11 of the first substrate by flip chip technology and the lower bridge arm chip 4 is connected to the connection copper layer 21 of the second substrate by flip chip technology, so that the upper bridge arm chip 3 and the lower bridge arm chip 4 are each flip-chip mounted in opposite directions on the two facing connection copper layers. Moreover, the connection copper layer 21 of the second substrate is connected to the upper surface of the upper bridge arm chip 3, and the connection copper layer 11 of the first substrate is connected to the upper surface of the lower bridge arm chip 4, so that current can flow through the upper bridge arm chip 3 and the lower bridge arm chip 4 between the connection copper layer 11 of the first substrate and the connection copper layer 21 of the second substrate, forming a commutation loop between the first substrate and the second substrate.

Since the flip chip method directly connects the chip to a substrate, carrier or circuit board through the bump surface of the chip, it has a smaller vertical dimension compared to wire bonding. Moreover, since the upper bridge arm chip 3 and the lower bridge arm chip 4 are mounted in opposite directions on the connection copper layer 11 of the first substrate and the connection copper layer 21 of the second substrate respectively, a commutation loop can be formed without requiring conductive spacers to connect the connection copper layer 11 of the first substrate and the connection copper layer 21 of the second substrate, reducing the number of components used and the lateral dimension of the power semiconductor module.

It will be understood that, since the connection copper layer 21 of the second substrate is connected to the upper surface of the upper bridge arm chip 3 and the connection copper layer 11 of the first substrate is connected to the upper surface of the lower bridge arm chip 4, and signal terminals 6 and power terminals 5 are respectively disposed on both sides between the connection copper layer 11 of the first substrate and the connection copper layer 21 of the second substrate, after all the above components have completed their respective connection relationships, the spacing between the first substrate 1 and the second substrate 2, the thickness of the upper bridge arm chip 3, the thickness of the lower bridge arm chip 4, the thickness of the signal terminals 6 and the thickness of the power terminals 5 are all equal.

When welding is used to connect the above components, a solder layer is formed on the surface where any component is connected to other components, so that the spacing between the first substrate 1 and the second substrate 2, the total thickness of the upper bridge arm chip 3 and the solder layers on both sides thereof, the total thickness of the lower bridge arm chip 4 and the solder layers on both sides thereof, the total thickness of the signal terminals 6 and the solder layers on both sides thereof, and the total thickness of the power terminals 5 and the solder layers on both sides thereof are all equal.

In an optional embodiment, a first conductive spacer is disposed between the connection copper layer 11 of the first substrate and the upper bridge arm chip 3, the connection copper layer 11 of the first substrate being connected to a bottom surface of the first conductive spacer, and a top surface of the first conductive spacer being connected to the bump surface of the upper bridge arm chip 3, such that the height of the upper surface of the upper bridge arm chip 3 is equal to the height of the upper surface of the signal terminals 6. A second conductive spacer is disposed between the connection copper layer 21 of the second substrate and the lower bridge arm chip 4, such that the connection copper layer 21 of the second substrate is connected to a bottom surface of the second conductive spacer, and a top surface of the second conductive spacer is connected to the bump surface of the lower bridge arm chip 4, such that the height of the upper surface of the lower bridge arm chip 4 is equal to the height of the lower surface of the signal terminals 6.

Specifically, commonly used signal terminal components have a greater thickness than chip components. Therefore, to compensate for this height difference, a first conductive spacer may be disposed between the connection copper layer 11 of the first substrate and the upper bridge arm chip 3, and a second conductive spacer may be disposed between the connection copper layer 21 of the second substrate and the lower bridge arm chip 4, so that the height of the upper surface of the upper bridge arm chip 3 equals the height of the upper surface of the signal terminals 6, and the height of the upper surface of the lower bridge arm chip 4 equals the height of the lower surface of the signal terminals 6. It will be understood that the upper surface of the signal terminals 6 refers to the surface of the signal terminals 6 facing towards the second substrate 2, and the lower surface of the signal terminals 6 refers to the surface of the signal terminals 6 facing towards the first substrate 1.

Therefore, after all the above components have completed their respective connection relationships, the spacing between the first substrate 1 and the second substrate 2, the overall thickness of the upper bridge arm chip 3 and the first conductive spacer, the overall thickness of the lower bridge arm chip 4 and the second conductive spacer, the thickness of the signal terminals 6 and the thickness of the power terminals 5 are all equal.

When welding is used to connect the above components, a solder layer is formed on the surface where any component is connected to other components, so that the spacing between the first substrate 1 and the second substrate 2, the overall thickness of the upper bridge arm chip 3 and the solder layers on both sides thereof together with the first conductive spacer and the solder layers on both sides thereof, the overall thickness of the lower bridge arm chip 4 and the solder layers on both sides thereof together with the second conductive spacer and the solder layers on both sides thereof, the total thickness of the signal terminals 6 and the solder layers on both sides thereof, and the total thickness of the power terminals 5 and the solder layers on both sides thereof are all equal.

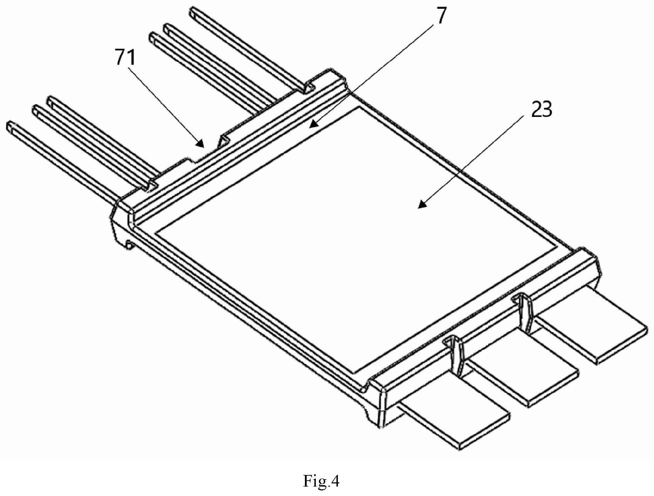

In an optional embodiment, as shown in Figure 4, the first substrate 1 and the second substrate 2 are spaced apart and mounted within an insulating housing 7 and overlap in the vertical direction, such that the connection copper layer 11 of the first substrate faces the connection copper layer 21 of the second substrate, and the outer copper layer 13 of the first substrate and the outer copper layer 23 of the second substrate face away from each other and are respectively exposed outside the insulating housing 7. The signal terminals 6 and the power terminals 5 are respectively exposed along a horizontal direction outside both sides of the insulating housing 7.

Specifically, the insulating housing 7 may be made of an epoxy resin material. The first substrate 1 and the second substrate 2 are spaced apart and mounted within the insulating housing 7, forming a structure in which the insulating housing 7 encloses the first substrate 1 and the second substrate 2. The insulating housing 7 can provide an insulating environment for the components contained therein, further improving the stability of the power semiconductor module during use. The outer copper layer 13 of the first substrate and the outer copper layer 23 of the second substrate are respectively exposed outside the insulating housing 7. It will be understood that the top surface and the bottom surface of the insulating housing 7 are provided with a substantially open-frame structure and do not cover the outer copper layer 13 of the first substrate and the outer copper layer 23 of the second substrate, so that the power semiconductor module can achieve a double-sided cooling effect through the outer copper layer 13 of the first substrate and the outer copper layer 23 of the second substrate. Further, heat dissipation equipment may be connected outside the top surface and the bottom surface of the insulating housing 7. Since the outer copper layer 13 of the first substrate and the outer copper layer 23 of the second substrate are respectively exposed outside the insulating housing 7, they can both be brought into contact with the heat dissipation equipment, thereby improving the efficiency of double-sided cooling of the power semiconductor module.

In an optional embodiment, a positioning groove 71 is provided on a side of the insulating housing 7 adjacent to the signal terminals 6, offset from a centre line of the insulating housing 7.

It will be understood that, given the above-described configuration of the power semiconductor module, the first substrate 1 and the second substrate 2 have similar structures and are arranged facing each other within the insulating housing 7. When the power semiconductor module is turned over, it is difficult to quickly determine the orientation of the power semiconductor, which may lead to confusion regarding the specific functions of the various signal terminals 6 and power terminals 5, adversely affecting subsequent connection to driver boards, capacitors or other equipment. Therefore, in the present embodiment, a positioning groove 71 is provided on a side of the insulating housing 7 adjacent to the signal terminals 6, offset from a centre line of the insulating housing 7. Since the positioning groove 71 is offset from the centre line of the insulating housing 7, the orientation of the first substrate 1 and the second substrate 2 can be determined based on the direction in which the positioning groove 71 is currently offset. By way of example, in Figure 4, when the positioning groove 71 is offset towards the left side of the insulating housing 7, it can be determined that the current orientation of the power semiconductor module is such that the second substrate 2 is located above the first substrate 1, and the positions of the signal terminals 6 and the power terminals 5 can be confirmed based on this orientation, thereby avoiding erroneous installation during the application of the power semiconductor module.

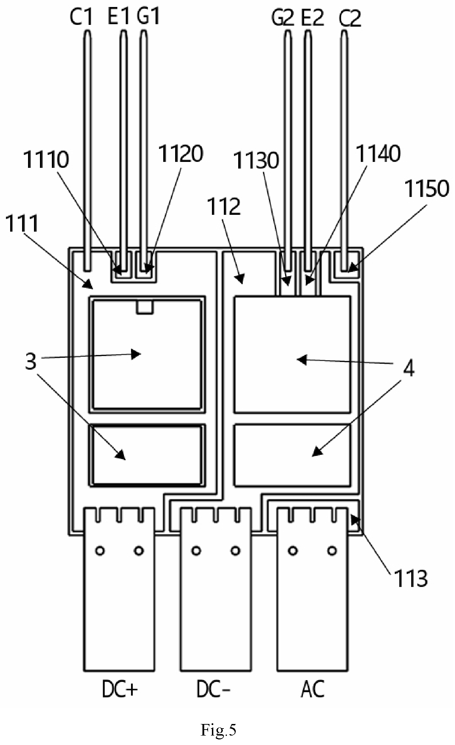

In an optional embodiment, as shown in Figures 5 to 6, the connection copper layer 11 of the first substrate comprises a first main copper foil 111, a second main copper foil 112 and a third main copper foil 113 that are mutually insulated, and the connection copper layer 21 of the second substrate comprises a fourth main copper foil 211, a fifth main copper foil 212 and a sixth main copper foil 213 that are mutually insulated. The first main copper foil 111 is connected to the bump surface of the upper bridge arm chip 3, the second main copper foil 112 is connected to the upper surface of the lower bridge arm chip 4, and the sixth main copper foil 213 is connected to the bump surface of the lower bridge arm chip 4 and the upper surface of the upper bridge arm chip 3.

The power terminals 5 comprise a DC positive terminal DC+, a DC negative terminal DC- and an AC terminal AC. The DC positive terminal DC+ connects the first main copper foil 111 and the fourth main copper foil 211, the DC negative terminal DC- connects the second main copper foil 112 and the fifth main copper foil 212, and the AC terminal AC connects the third main copper foil 113 and the sixth main copper foil 213.

After the above configuration, commutation loop current enters the first main copper foil 111 from the DC positive terminal DC+, flows through the bump surface of the upper bridge arm chip 3, and enters the sixth main copper foil 213 through the upper surface of the upper bridge arm chip 3. The current then flows through the AC terminal AC and the bump surface of the lower bridge arm chip 4, and enters the second main copper foil 112 through the upper surface of the lower bridge arm chip 4, and exits the power semiconductor module from the DC negative terminal DC-.

Preferably, as shown in Figures 5 to 6, the connection copper layer 11 of the first substrate further comprises a first auxiliary copper foil 1110, a second auxiliary copper foil 1120, a third auxiliary copper foil 1130, a fourth auxiliary copper foil 1140 and a fifth auxiliary copper foil 1150 that are mutually insulated, and the third auxiliary copper foil 1130 and the fourth auxiliary copper foil 1140 are respectively connected to the upper surface of the lower bridge arm chip 4.

The connection copper layer 21 of the second substrate further comprises a sixth auxiliary copper foil 2110, a seventh auxiliary copper foil 2120, an eighth auxiliary copper foil 2130, a ninth auxiliary copper foil 2140 and a tenth auxiliary copper foil 2150 that are mutually insulated, and the seventh auxiliary copper foil 2120 and the eighth auxiliary copper foil 2130 are respectively connected to the upper surface of the upper bridge arm chip 3.

The signal terminals 6 comprise a first collector signal terminal C1, a second collector signal terminal C2, a first emitter signal terminal E1, a second emitter signal terminal E2, a first gate signal terminal G1 and a second gate signal terminal G2. The first collector signal terminal C1 connects the first main copper foil 111 and the sixth auxiliary copper foil 2110, the first emitter signal terminal E1 connects the first auxiliary copper foil 1110 and the seventh auxiliary copper foil 2120, the first gate signal terminal G1 connects the second auxiliary copper foil 1120 and the eighth auxiliary copper foil 2130, the second collector signal terminal C2 connects the fifth auxiliary copper foil 1150 and the sixth main copper foil 213, the second emitter signal terminal E2 connects the fourth auxiliary copper foil 1140 and the tenth auxiliary copper foil 2150, and the second gate signal terminal G2 connects the third auxiliary copper foil 1130 and the ninth auxiliary copper foil 2140.

After the above configuration, commutation loop current enters the first main copper foil 111 from the DC positive terminal DC+, flows through the first collector signal terminal C1 and the bump surface of the upper bridge arm chip 3 in the first main copper foil 111, and enters the sixth main copper foil 213, the seventh auxiliary copper foil 2120 and the eighth auxiliary copper foil 2130 through the upper surface of the upper bridge arm chip 3. The current respectively flows through the first emitter signal terminal E1, the first gate signal terminal G1, the AC terminal AC, the second collector signal terminal C2 and the bump surface of the lower bridge arm chip 4, and then enters the second main copper foil 112, the third auxiliary copper foil 1130 and the fourth auxiliary copper foil 1140 through the upper surface of the lower bridge arm chip 4, flows through the second emitter signal terminal E2 and the second gate signal terminal G2, and exits the power semiconductor module from the DC negative terminal DC-.

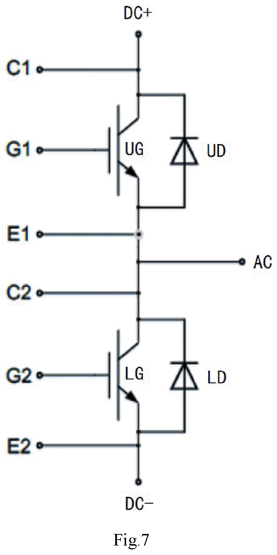

Preferably, the upper bridge arm chip 3 comprises an upper bridge arm IGBT chip UG and an upper bridge arm diode chip UD, and the lower bridge arm chip 4 comprises a lower bridge arm IGBT chip LG and a lower bridge arm diode chip LD. The circuit topology of the commutation loop achieved is shown in Figure 7.

Preferably, the connection copper layer 11 of the first substrate is connected to the bump surface of the upper bridge arm chip 3 by vacuum reflow soldering, and the connection copper layer 21 of the second substrate is connected to the upper surface of the upper bridge arm chip 3 by vacuum reflow soldering. The connection copper layer 21 of the second substrate is connected to the bump surface of the lower bridge arm chip 4 by vacuum reflow soldering, and the connection copper layer 11 of the first substrate is connected to the upper surface of the lower bridge arm chip 4 by vacuum reflow soldering.

It will be understood that, in an embodiment using the first conductive spacer and the second conductive spacer, the method further comprises: the connection copper layer 11 of the first substrate is connected to the bottom surface of the first conductive spacer by vacuum reflow soldering, the top surface of the first conductive spacer is connected to the bump surface of the upper bridge arm chip 3 by vacuum reflow soldering, the connection copper layer 21 of the second substrate is connected to the bottom surface of the second conductive spacer by vacuum reflow soldering, and the top surface of the second conductive spacer is connected to the bump surface of the lower bridge arm chip 4 by vacuum reflow soldering.

Preferably, the first conductive spacer and the second conductive spacer comprise a material selected from aluminium silicon carbide, a molybdenum copper alloy or copper.

The present invention further discloses a power semiconductor packaging assembly, comprising at least three power semiconductor modules as described above, the power semiconductor modules being arranged side by side in the same orientation. Heat sinks are connected to the outer copper layer of the first substrate and the outer copper layer of the second substrate of each of the power semiconductor modules respectively.

Specifically, in the above packaging assembly, the power semiconductor modules are arranged side by side in the same orientation. It will be understood that the power terminals of each power semiconductor module are distributed on the same side, and the directions of the first substrate and the second substrate within each power semiconductor module are the same. Further, the packaging assembly may be externally connected to heat dissipation equipment in contact with the outer copper layers of each power semiconductor module, thereby simultaneously achieving double-sided cooling of each power semiconductor module within the packaging assembly. The packaging assembly obtained above is compatible with silicon-based power chips and silicon carbide power chips, and can be used to form a single three-phase full-bridge inverter, a dual three-phase full-bridge inverter, a Boost circuit and other power electronic circuits, and can be applied in motor control modules and vehicle assemblies.

After adopting the above-mentioned technical solution, the following beneficial effects are achieved compared with the prior art: by means of flip chip technology, the bump surface of the chip is directly connected to the connection copper layer, thereby reducing the vertical dimension of the power semiconductor module; by mounting the upper bridge arm chip and the lower bridge arm chip in opposite directions on the first substrate and the second substrate respectively, the number of spacers connecting the first substrate and the second substrate can be reduced, thereby reducing the lateral dimension of the power semiconductor module; and by providing exposed outer copper layers, the power semiconductor module is enabled to perform double-sided cooling.

It should be noted that the embodiments of the present invention have relatively good practical applicability and are not intended to limit the present invention in any form. Any person skilled in the art may utilise the technical content disclosed above to modify or alter the embodiments into equivalent embodiments without departing from the scope of the technical solution of the present invention. Any modifications, equivalent variations and alterations made to the above embodiments according to the technical essence of the present invention shall fall within the scope of the technical solution of the present invention, so long as they do not depart from the content of the technical solution of the present invention.

## Claims

1. A power semiconductor module with double-sided cooling, **characterised in that**:
it comprises a first substrate and a second substrate, each of the first substrate and the second substrate comprising a connection copper layer, an insulating dielectric layer and an outer copper layer that are arranged in a bonded configuration, the insulating dielectric layer being disposed between the connection copper layer and the outer copper layer;
the first substrate and the second substrate are spaced apart and overlap in a vertical direction, such that the connection copper layer of the first substrate faces the connection copper layer of the second substrate;
an upper bridge arm chip is disposed on the connection copper layer of the first substrate, the connection copper layer of the first substrate being connected to a bump surface of the upper bridge arm chip, and the connection copper layer of the second substrate being connected to an upper surface of the upper bridge arm chip;
a lower bridge arm chip is disposed on the connection copper layer of the second substrate, the connection copper layer of the second substrate being connected to a bump surface of the lower bridge arm chip, and the connection copper layer of the first substrate being connected to an upper surface of the lower bridge arm chip; and
signal terminals and power terminals are respectively disposed on both sides between the connection copper layer of the first substrate and the connection copper layer of the second substrate.

2. The power semiconductor module according to claim 1, **characterised in that**:
a first conductive spacer is disposed between the connection copper layer of the first substrate and the upper bridge arm chip, the connection copper layer of the first substrate being connected to a bottom surface of the first conductive spacer, and a top surface of the first conductive spacer being connected to the bump surface of the upper bridge arm chip, such that a height of the upper surface of the upper bridge arm chip is equal to a height of an upper surface of the signal terminals;
a second conductive spacer is disposed between the connection copper layer of the second substrate and the lower bridge arm chip, such that the connection copper layer of the second substrate is connected to a bottom surface of the second conductive spacer, and a top surface of the second conductive spacer is connected to the bump surface of the lower bridge arm chip, such that a height of the upper surface of the lower bridge arm chip is equal to a height of a lower surface of the signal terminals.

3. The power semiconductor module according to claim 1, **characterised in that**:
the first substrate and the second substrate are spaced apart and mounted within an insulating housing and overlap in the vertical direction, such that the connection copper layer of the first substrate faces the connection copper layer of the second substrate, and the outer copper layer of the first substrate and the outer copper layer of the second substrate face away from each other and are respectively exposed outside the insulating housing; and
the signal terminals and the power terminals are respectively exposed along a horizontal direction outside both sides of the insulating housing.

4. The power semiconductor module according to claim 3, **characterised in that**:
a positioning groove is provided on a side of the insulating housing adjacent to the signal terminals, offset from a centre line of the insulating housing.

5. The power semiconductor module according to claim 1, **characterised in that**:
the connection copper layer of the first substrate comprises a first main copper foil, a second main copper foil and a third main copper foil that are mutually insulated, and the connection copper layer of the second substrate comprises a fourth main copper foil, a fifth main copper foil and a sixth main copper foil that are mutually insulated;
the first main copper foil is connected to a bump surface of the upper bridge arm chip, the second main copper foil is connected to an upper surface of the lower bridge arm chip, and the sixth main copper foil is connected to a bump surface of the lower bridge arm chip and an upper surface of the upper bridge arm chip;
the power terminals comprise a DC positive terminal, a DC negative terminal and an AC terminal, the DC positive terminal connects the first main copper foil and the fourth main copper foil, the DC negative terminal connects the second main copper foil and the fifth main copper foil, and the AC terminal connects the third main copper foil and the sixth main copper foil;
commutation loop current enters the first main copper foil from the DC positive terminal, flows through the upper bridge arm chip and then enters the sixth main copper foil, flows through the AC terminal and the lower bridge arm chip, and then enters the second main copper foil, and exits the power semiconductor module from the DC negative terminal.

6. The power semiconductor module according to claim 5, **characterised in that**:
the connection copper layer of the first substrate further comprises a first auxiliary copper foil, a second auxiliary copper foil, a third auxiliary copper foil, a fourth auxiliary copper foil and a fifth auxiliary copper foil that are mutually insulated, and the third auxiliary copper foil and the fourth auxiliary copper foil are respectively connected to an upper surface of the lower bridge arm chip;
the connection copper layer of the second substrate further comprises a sixth auxiliary copper foil, a seventh auxiliary copper foil, an eighth auxiliary copper foil, a ninth auxiliary copper foil and a tenth auxiliary copper foil that are mutually insulated, and the seventh auxiliary copper foil and the eighth auxiliary copper foil are respectively connected to an upper surface of the upper bridge arm chip;
the signal terminals comprise a first collector signal terminal, a second collector signal terminal, a first emitter signal terminal, a second emitter signal terminal, a first gate signal terminal and a second gate signal terminal;
the first collector signal terminal connects the first main copper foil and the sixth auxiliary copper foil, the first emitter signal terminal connects the first auxiliary copper foil and the seventh auxiliary copper foil, the first gate signal terminal connects the second auxiliary copper foil and the eighth auxiliary copper foil, the second collector signal terminal connects the fifth auxiliary copper foil and the sixth main copper foil, the second emitter signal terminal connects the fourth auxiliary copper foil and the tenth auxiliary copper foil, and the second gate signal terminal connects the third auxiliary copper foil and the ninth auxiliary copper foil;
commutation loop current enters the first main copper foil from the DC positive terminal, flows through the first collector signal terminal and the upper bridge arm chip and then enters the sixth main copper foil, the seventh auxiliary copper foil and the eighth auxiliary copper foil, respectively flows through the first emitter signal terminal, the first gate signal terminal, the AC terminal, the second collector signal terminal and the lower bridge arm chip, and then enters the second main copper foil, the third auxiliary copper foil and the fourth auxiliary copper foil, flows through the second emitter signal terminal and the second gate signal terminal, and exits the power semiconductor module from the DC negative terminal.

7. The power semiconductor module according to claim 1, **characterised in that**:
the upper bridge arm chip comprises an upper bridge arm IGBT chip and an upper bridge arm diode chip, and the lower bridge arm chip comprises a lower bridge arm IGBT chip and a lower bridge arm diode chip.

8. The power semiconductor module according to claim 1, **characterised in that**:
the connection copper layer of the first substrate is connected to the bump surface of the upper bridge arm chip by vacuum reflow soldering, and the connection copper layer of the second substrate is connected to an upper surface of the upper bridge arm chip by vacuum reflow soldering;
the connection copper layer of the second substrate is connected to the bump surface of the lower bridge arm chip by vacuum reflow soldering, and the connection copper layer of the first substrate is connected to an upper surface of the lower bridge arm chip by vacuum reflow soldering.

9. The power semiconductor module according to claim 2, **characterised in that**:
the first conductive spacer and the second conductive spacer comprise a material selected from aluminium silicon carbide, a molybdenum copper alloy or copper.

10. A power semiconductor packaging assembly, **characterised in that** it comprises:
at least three power semiconductor modules according to any one of claims 1 to 9, the power semiconductor modules being arranged side by side in the same orientation;
heat sinks connected to the outer copper layer of the first substrate and the outer copper layer of the second substrate of each of the power semiconductor modules respectively.
